# EUROPEAN PATENT APPLICATION

(11) **EP 3 770 894 A1**
(43) Date of publication of application: **27.01.2021**
(21) Application number: 20187164.7
(22) Date of filing: 22.07.2020
(51) Int. Cl.: G09G 3/3225, G09G 3/20, H01L 27/32

(54) **AN OLED DISPLAY CONFIGURATION AND METHOD OF DRIVING THEREOF**

(30) Priority: 23.07.2019 GB 201910485
(71) Applicant: Continental Automotive GmbH, 30165 Hannover (DE)
(72) Inventor: Dubey, Arvind, Singapore 339780 (SG); Jung, Samuel, Singapore 339780 (SG); Lee, Fook Wai, Singapore 339780 (SG)
(74) Representative: Lee, Jun-Hoe Daniel

(57) **Abstract**

An OLED display configuration and method of driving the same is disclosed herein. The OLED display comprises a controller electrically connected to a plurality of pixel structures to produce images. Each pixel structure comprises two sub-pixels, in which one of the two sub-pixels is a complementary pixel. The controller is configured to alternately illuminate the two sub-pixels. The two sub-pixels are alternately illuminated to switch on and switch off the two-sub pixels. In the alternative, the OLED display is further electrically connected to a control circuitry including a calculation unit, for calculating a grayscale value of the complementary pixel, thereby alternately illuminating the two-sub pixels in a colour value and a grayscale value.

## Description

### TECHNICAL FIELD

The present disclosure relates to display technology, in particular organic light emitting diode (OLED) display configurations and method of driving the same.

### BACKGROUND

The automotive industry is moving towards the trend of using flat display technologies to replace conventional instrumentation panels. The most commonly used panel display technologies in automotive industry are liquid crystal display (LCD). Although not commonly used in automotive applications, OLED displays has several advantages. An OLED display can be fabricated on plastic substrates, resulting in lightweight displays in comparison to LCD displays which are fabricated on glass substrates. OLEDs produces images in higher resolution due to a greater contrast ratio and wider viewing angle, and response time is much higher as compared with LCD displays20170. The aforesaid advantages are attractive for using OLED technologies in automotive, where the display units are normally mounted within an interior of a vehicle cabin, used to displaying vehicle information and vehicle safety warnings to a driver.

However, OLED displays have the disadvantages of short lifespan due to luminance decay and image burn-in. Burn-in is a form of image retention where a faint image of a previous video data that was scanned and displayed on the OLED display appears even after subsequent contents are displayed on the same OLED display, leaving a static image on the display panel and possibly shortening the lifespan of the OLED display. The problem of luminance decay occurs due to the amount of current passing through the pixels in that more current passing through the pixels causes more decay in the pixels. In a conventional display, the rate of luminance decay is different between each colour phosphors, i.e. red, blue and green (RGB).

Luminance decay causes non-uniformity in luminance of a display device, thus affecting the resolution of images displayed on the display device. A known solution is to improve decayed luminance by adjusting the brightness of each pixel so that the brightness of the display is uniform when viewed by a user. However, this solution may not resolve burn-in issues.

A possible solution to prevent burn-in issues is to mask out the static image. However, this solution may not produce visually appealing images when burn-in issues occur.

Another possible solution to improve the lifespan and burn-in issues in OLED displays is to use phosphorescent organic light emitting diodes (PHOLED), which offer higher quantum efficiency as compared to fluorescent OLEDs. Since PHOLED technology is still very new and relatively more expensive, PHOLED displays are more commonly used in high-end luxury sports car.

### SUMMARY

A purpose of this disclosure is to provide a solution to solve the problem of luminance decay of OLED displays.

Another purpose of this disclosure is to solve the problem of image burn-in issues in OLED displays.

Yet another purpose of this disclosure is to solve the problem of short lifespan of OLED displays caused by degradation of organic material over time, which causes formation of dark spots.

In a first aspect of this disclosure, an OLED display is provided. The OLED display comprises a controller electrically connected to a plurality of pixel structures to produce images. Each pixel structure comprises of two sub-pixels. The controller is configured to alternately illuminate the sub-pixels.

At least three pixel structures may be configured to be layered within a same area to form a predetermined colour mode. This colour mode may be for instance red, blue, green (RGB), to make up one collection of RGB pixel structures. Each pixel structure may be configured to illuminate a different colour. Thus, each pixel structure may be layered or stacked on each other so that the different illuminated colours are able to mix to generate a range of colours.

The layered pixel structures may be repeatedly arranged to form the plurality of pixel structures for producing images.

The layered pixel structures may be repeatedly arranged along the plane of the OLED display to form the display.

The controller may be configured to illuminate one sub-pixel and not illuminate the other sub-pixel. The illuminated sub-pixel may be controlled to illuminate according to the actual image or frame data, while the other sub-pixel remains switched off by the controller. For video or moving images, to produce a first frame, one sub-pixel may be illuminated and the other sub-pixel may not be illuminated, and in the next frame, the illuminated sub-pixel is then switched off while the other sub-pixel is illuminated.

Alternatively, the controller may be configured to illuminate one sub-pixel, e.g. according to actual image or frame data, such as in full colour, and illuminate the other sub-pixel in grayscale. One sub-pixel may be illuminated and the other sub-pixel may be illuminated in grayscale in a first frame, and one sub-pixel may be illuminated in grayscale and the other sub-pixel may be illuminated in a second frame.

In a second aspect of this disclosure, a method of driving an OLED display is disclosed. The method comprises of generating signals converted from video data by a controller and alternately illuminating sub-pixels of each pixel structure, based on the signals generated, to produce video frames associated with the video data.

Alternately illuminating may comprise of illuminating one sub-pixel and not illuminating the other sub-pixel. For video frames, alternately illuminating may comprise of illuminating one sub-pixel based on the signal generated and not illuminating the other sub-pixel to produce a first frame, and switching off or not illuminating one sub-pixel and illuminating the other sub-pixel based on the signal generated to produce a second frame.

In an alternative, alternately illuminating may comprise of illuminating one sub-pixel and illuminating the other sub-pixel in grayscale. The method of alternately illuminating may comprise illuminating one sub-pixel based on the signal generated and illuminating the other sub-pixel in grayscale to produce a first frame, and illuminating one sub-pixel in grayscale and illuminating the other sub-pixel based on the signal generated to produce a second frame.

This disclosure advantageously achieves the purpose of providing a solution to solve the problem of luminance decay of OLED display, by alternately illuminating two or possibly more sub-pixels of an OLED display. In particular, the concept of introducing a sub-pixel or complementary pixel provides an additional degree of freedom or a redundancy to prolong the lifetime and reduce the burn-in of each pixel or pixel structure.

Advantageously, the purpose of providing a solution to solve the problem of image burn-in issues in OLED displays is achieved when redundant sub-pixels are used since a burned-in image will not be present when images are displayed by alternate sub-pixels. In an exemplary embodiment where a grayscale value of a complementary pixel is illuminated, the resolution of the images displayed appears twice as full when viewed by a user, as compared to conventional displays without a complementary pixel configuration, due to the introduction of a complementary pixel.

Advantageously, the purpose of providing a solution to solve the problem of short life span of the OLED display is achieved since each sub-pixel is in full operation half of the time the display is in operation.

### BRIEF DESCRIPTION OF DRAWINGS

Other objects and aspects will become apparent from the following description of embodiments with reference to the accompany drawings in which:
FIG. 1 shows a system block diagram according to an embodiment.
FIG. 2 shows a collection of pixel structures representing a part of an OLED display according to an embodiment.
Fig. 3 shows three frames of an OLED display according to an embodiment.

### DETAILED DESCRIPTION OF EMBODIMENTS

Hereinafter, exemplary embodiments of an OLED display and method of driving thereof will be discussed in detail below.

The expression "configured to" may denote, and may be interchangeably used with "suitable for", "having the capacity to", "designed to", "adapted to", "made to", or "capable of" according to a situation, for example. The term "configured to" may not necessarily mean "specifically designed to" in terms of hardware. Instead, the expression "a device configured to" in some situations may mean that the device and another device or part are "capable of" carrying out a function.

The term "first", "second", and the like hereinafter may refer to modifying various elements of various embodiments of the present disclosure, but do not limit the elements. The expressions may be used to distinguish one element from another element. For instance, "a first frame" and "a second frame" may refer to two different frames regardless of sequence of importance. Similarly, the first frame may be referred to as the second frame and vice versa without departing from the scope of the present disclosure.

The term "pixel" denotes a small area, a grid or a display element which can be given a colour value, typically red, green or blue (RGB), thus producing a colour scheme or colour mode comprising primary colours, to produce coloured imaging when displayed. Alternatively, there may be four components of colours, for instance red, green, blue and white (RGBW). It is possible to achieve other colour modes, e.g. yellow, cyan and magenta (CYM), according to design specifications, using three or four colour components as desired.

The term "complementary pixel" denotes an additional or auxiliary pixel used to enhance or emphasize the qualities of pixels of a display screen, to improve on the resolution of a display unit. The term "complementary pixel" is synonymous with the term "sub-pixel".

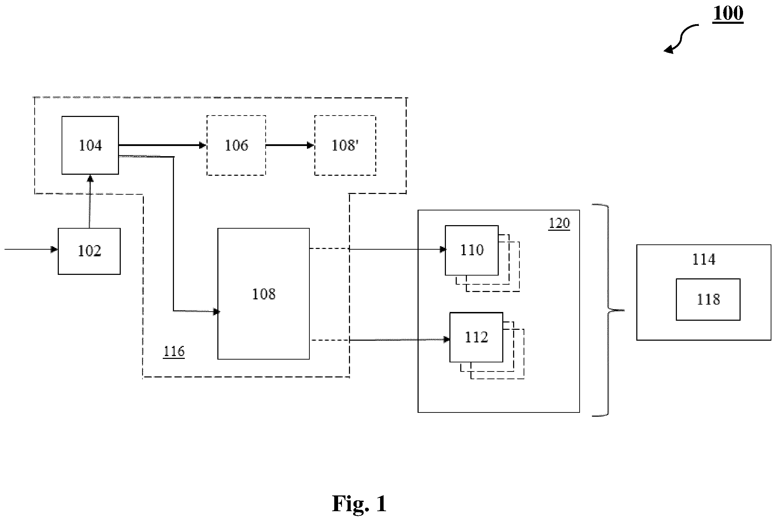

Referring now to the accompanying drawings, Fig. 1 shows a system block diagram 100 of an exemplary embodiment, where an organic light emitting (OLED) display 120 is electrically connected to hardware components: an interface 102, controller 104, and a control circuitry 116. The OLED display 120 comprises of a plurality of OLED pixel structures 114 arranged within an area or a grid, for example rows and columns along a substrate to form the entire OLED display 120. The substrate may be a plastic substrate or a foil substrate. Arranging the plurality of OLED pixel structures 114 within a grid in the form of red, green and blue (RGB) will result in an RGB colour mode. The RGB colour mode is operable to display coloured images on a display when the display is scanned. Each pixel structure in a collection may be layered or stacked on each another, in a direction perpendicular to the substrate of the display, to thereby allow the different colour values to mix and generate a range of colours. As illustrated in Fig. 1, the sub-pixel 110 has layers of other sub-pixels 110 behind it (represented by the dotted lines), and sub-pixel 112 has layers of other sub-pixels 112 behind it. Thus, a collection of pixels provides a predetermined colour mode 118, eg. RGB colour mode. In a conventional OLED display, when scanning techniques are applied, the plurality of OLED pixel structures is illuminated, to produce an image for display on the OLED display 120.

Each of the plurality of OLED pixel structure 114 comprises of two sub-pixels 110, 112, in which one of the two sub-pixels is a complementary pixel 112. The complementary pixel 112 may be an electrode, an organic emissive material or a thin film transistor (TFT), similar to the regular pixel 110. The complementary pixel 112 share the same location or area as the regular pixel 110. As mentioned above, the complementary pixel provides an additional degree of freedom or a redundancy to prolong the lifetime and reduce the burn-in of each pixel or pixel structure. An exemplary embodiment using such configuration applies scanning techniques which illuminates the regular pixel 110 in the predetermined colour mode 118 and illuminates the complementary pixel 112 in grayscale. The aforesaid configuration achieves a double resolution effect, i.e. if a display has a physical size of 100 by 100 pixels per inch (PPI), by adapting the pixel configuration disclosed herein, a resolution of 200 by 200 PPI is achieved, given the same display area. Typically, a "complementary pixel" has the same intensity or colour mode to its neighbouring regular pixel.

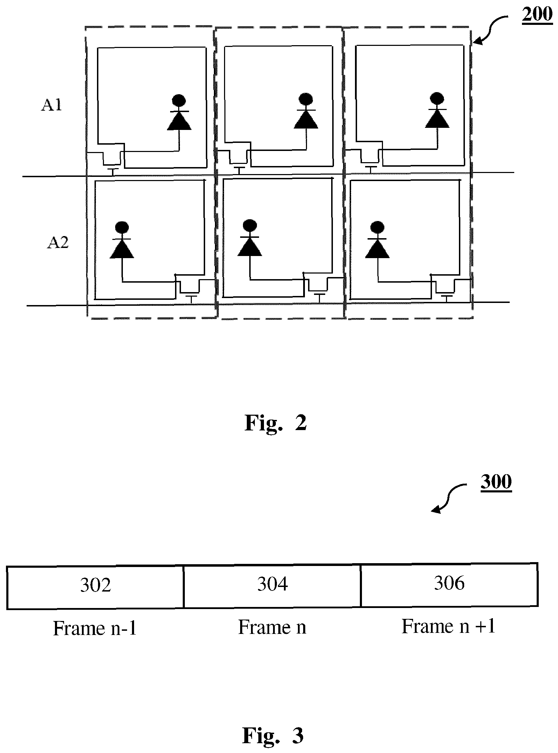

The interface 102 is a device used for receiving video data or images to be displayed on the OLED display 120. By way of an example, the interface 102 may be a vehicle camera on a motor vehicle used for surround view monitoring external of the vehicle. The OLED display 120 is made up of the plurality of OLED pixel structures 114 arranged in the matrix pattern as shown in Fig. 2. During scanning, each of the plurality of pixel structure 114 is illuminated, to form a pixel of a graphical or video image.

A control circuitry 116 electrically connects the plurality of OLED pixel structures 114 to the interface 102. The control circuitry 116 comprises of a controller 104, an optional calculation unit 106 and one or more drivers, i.e. scan lines driver 108 and data lines driver 108', all of which are electrically connected to the plurality of pixel structures 114. In an exemplary embodiment, a single driver is used to drive both scan lines and data lines. The controller 104 performs the function of generating signals to display images or text on a display unit 100. The controller 104 may include a microprocessor or non-transitory computer-readable medium (not shown in Fig. 1) for executing command to illuminate OLED display 120, thereby converting video data into images and displaying the images on OLED display 120. The controller 104 acquires video or image data from the interface 102 and communicates the generated signals to the one or more drivers 108, 108' to drive the scan lines and data lines.

The optional calculation unit 106 is configured to calculate a grayscale value of the complementary pixel 112. The grayscale value may be calculated to complement the full colour illuminated by the regular pixel 110. The optional calculation unit 106 may be a function or algorithm stored in the non-transitory computer-readable medium within the controller 104 or in a separate non-transitory computer medium, for executing instructions to perform the calculation of grayscale value required to illuminate complementary pixel 112. The calculation unit 106 allows computation of a calculated grayscale to be displayed by a complementary pixel 112, to enhance the illuminance of the display unit 112 by displaying the sub-pixel 112 in grayscale as computed by the calculation unit 106. In embodiments where one sub-pixel (110) is illuminated and the other sub-pixel (112) is not, the control circuitry 116 may not include a calculation unit 106.

As shown in Fig. 2 are two rows of pixel structures, A1 and A2, which represent a collection of plurality of pixel structures 114. The first row A1 has a first layer of three pixel structures arranged side by side and the second row A2 shows a second layer of three pixel structures. Row A1 is stacked on row A2 in a direction perpendicular to the substrate of the display. There may be further rows as necessary in accordance with the predetermined colour mode 118. The three pixel structures of each layer shown in Fig. 2 are representative and there may be more pixel structures in each layer arranged in a direction parallel to the substrate of the display to form the OLED display. The layered pixel structures are repeatedly or closely arranged to form a plurality of pixel structures 114, forming a display panel frames regardless of the order or the importance. During scanning, each pixel structure is configured to alternately illuminate in accordance to any one of the exemplary embodiments as disclosed in this document, thus producing an image based upon data received from interface 102.

In an exemplary embodiment, the driver 108, 108' alternately illuminate the plurality of pixels of OLED display 120 such that the first sub-pixel 110 is switched on, i.e. illuminated, and the second sub-pixel or complementary pixel 112 is switched off, i.e. no light is illuminated through the complementary pixel 112. This mode of alternate illumination is repeated throughout all the plurality of pixel structures on the OLED display 120. In another exemplary embodiment, the first sub-pixel 110 is switched on, i.e. illuminated in the predetermined colour mode 118, and the second sub-pixel 112 is illuminated in a calculated grayscale value. When each pixel structure 114 is repeatedly alternately illuminated in the aforesaid mode, an image display on the OLED display 120 appears to be in full resolution when viewed. Alternately illuminating sub-pixels achieves the objective of prolonging the lifespan of the OLED display 120 by mitigating burn-in and luminance decay issues.

In another exemplary embodiment, the driver 108, 108' is configured to alternately illuminate the sub-pixel 110, i.e. the sub-pixel 110 is illuminated in the predetermined colour mode 118, showing an actual data of signals generated from the video data received from the interface 102, and the other sub-pixel or the complementary pixel 112 is illuminated in grayscale, based on a grayscale value calculated by the calculation unit 106. This mode of alternately illumination is repeated throughout all the plurality of pixel structures within the OLED display 120. An image displayed on the OLED display 120 will thus appear to be in full resolution, or double resolution effect when viewed. In this manner, the intensity of the display is not compromised and thus the objective of the prolonging the lifespan of the OLED display by preventing burn-in issues is achieved.

Turning now to Fig. 3 three frames are shown, namely frame n-1 302, frame n 304 and frame n+1 306, where n is a frame being displayed at time n. In an exemplary embodiment, at frame n-1 302, the actual data is displayed in colour mode in sub-pixel 110, i.e. the pixel is illuminated in the predetermined colour mode 118. In a first frame 302, an actual data of an image input (e.g. a red colour value) or a video data is displayed by a first sub-pixel 110, and a calculated grayscale value is displayed by a second sub-pixel 112. In the second frame 304, a calculated grayscale value is displayed by a first sub-pixel 110 and an actual data of an image input or a video data is displayed by a second sub-pixel 112. In a third frame 306, the actual data of the image input, or the video data is displayed by the first sub-pixel 110 and the calculated grayscale value is displayed by the second sub-pixel 112.

In another embodiment, the OLED display 120 when alternately illuminated in a direct interlaced mode, in the first row A1 of a first frame 302, the first sub-pixel 110 is being illuminated, thus displaying the actual data of the video data received from the interface 102 and in the second row A2 of the first frame 302, the second sub-pixel 112 not illuminated, i.e. switched off. The illumination is alternate, such that the at least one driver 108, 108' drives the OLED display 120 such that in a second frame 304, in the first row A1, the first sub-pixel 110 of pixel structure 114 is not illuminated, i.e. switched off, and the second sub-pixel 112 is illuminated, thus displaying the actual data of the video data received from the interface 102. In a third frame 306, , the first sub-pixel 110 of pixel structure 114 is being illuminated, thus displaying the actual data of the video data received from the interface 102 and in the second row A2, the second sub-pixel 112 not illuminated, i.e. switched off.

When the OLED display 120 configuration disclosed herein is driven in alternatingly actual data and grayscale mode, the images when viewed will appear to be in full resolution. Accordingly, the objective of prolonging lifespan and prevention of burn-in issues of the display is achieved.

A method of driving an OLED display according to a preferred embodiment as disclosed herein. In a first step, the method involves generating signals converted from video data by at least one driver (108, 108'). In a next step, the method involves alternately illuminating sub-pixels 110, 112 comprised in a pixel structure 114 based on the signals generated.

In an exemplary embodiment, additional steps involving receiving video data inputs from an interface 102 electrically connected to the OLED display is required. A control circuitry 116 for performing the function of processing video data inputs received from the interface 106 for producing images on the OLED display 120 is electrically connected to the OLED display 100. The control circuitry 116 further comprises of a calculation unit 106 for calculating a grayscale value required for illuminating the OLED display 120.

In an embodiment, the step involving alternately illuminating comprises of illuminating one sub-pixel 110 and not illuminating the other sub-pixel 112.

Alternatively, the step involving alternately illuminating comprises of illuminating one sub-pixel 110 to produce a first frame 302 and illuminating the other sub-pixel 112 to produce a second frame 304.

In another alternative embodiment, the step involving alternately illuminating comprises of illuminating one sub-pixel 110 and illuminating the other sub-pixel 112 in grayscale.

In yet another alternative embodiment, the step involving alternately illuminating comprises in a first frame 302, illuminating one sub-pixel 110 based on the signal generated and illuminating the other sub-pixel 112 in grayscale and, in a second frame 304, illuminating one sub-pixel 110 in grayscale and illuminating the other sub-pixel 112 based on the signal generated.

The detailed description above serves the purpose of explaining the principles of the present disclosure and its practical application, thereby enabling others skilled in the art to understand the disclosure for various exemplary embodiments and with various modifications as are suited to the particular use contemplated. The detailed description is not intended to be exhaustive or to limit the present disclosure to the precise embodiments herein. Modifications and equivalents will be apparent to practitioners skilled in the relevant art and are encompassed within the scope and spirit of the appended claims.

### List of Reference Signs

- 100 -: System block diagram
- 102 -: interface
- 104 -: controller
- 106 -: calculation unit
- 108 -: scan line drivers
- 110 -: regular sub-pixel
- 112 -: complementary pixel
- 114 -: plurality of OLED pixel structures
- 116 -: control circuitry
- 118 -: predetermined colour mode
- 120 -: OLED display

- 200 -: Display frames

- 302 -: First frame / Frame n-1
- 304 -: Second frame / Frame n
- 306 -: Third frame / Frame n + 1

## Claims

1. An OLED display (120) comprising a controller (104) electrically connected to a plurality of pixel structures to produce images, wherein each pixel structure (114) comprises of two sub-pixels (110, 112), wherein the controller (104) is configured to alternately illuminate the sub-pixels (110, 112).

2. The OLED display (120) of Claim 1, wherein at least three pixel structures are configured to be layered within a same area to form a predetermined colour mode (118), each pixel structure (114) configured to illuminate a different colour.

3. The OLED display (120) of Claim 2, wherein the layered pixel structures are repeatedly arranged to form the plurality of pixel structures.

4. The OLED display (120) of Claim 1, wherein the controller (104) is configured to illuminate one sub-pixel (110) and not illuminate the other sub-pixel (112).

5. The OLED display (120) of Claim 4, wherein one sub-pixel (110) is illuminated and the other sub-pixel (112) is not illuminated in a first frame (302), and one sub-pixel (110) is not illuminated and the other sub-pixel (112) is illuminated in a second frame (304).

6. The OLED display (120) of Claim 1, wherein the controller (104) is configured to illuminate one sub-pixel (110) and illuminate the other sub-pixel (112) in grayscale.

7. The OLED display (120) of Claim 6, wherein one sub-pixel (110) is illuminated and the other sub-pixel (112) is illuminated in grayscale in a first frame (302), and one sub-pixel (110) is illuminated in grayscale and the other sub-pixel (112) is illuminated in a second frame (304).

8. A method of driving an OLED display (120), the method comprising:
generating signals converted from video data by a controller (104);
alternately illuminating sub-pixels (110, 112) of each pixel structure (114) of the OLED display (120), based on the signals generated, to produce video frames associated with the video data.

9. The method of Claim 8, wherein alternately illuminating comprises: illuminating one sub-pixel (110) and not illuminating the other sub-pixel (112).

10. The method of Claim 9, wherein alternately illuminating comprises: illuminating one sub-pixel (110) based on the signal generated and not illuminating the other sub-pixel (112) to produce a first frame (302); and not illuminating one sub-pixel (110) and illuminating the other sub-pixel (112) based on the signal generated to produce a second frame (304).

11. The method of Claim 8, wherein alternately illuminating comprises: illuminating one sub-pixel (110) and illuminating the other sub-pixel (112) in grayscale.

12. The method of Claim 11, wherein alternately illuminating comprises: illuminating one sub-pixel (110) based on the signal generated and illuminating the other sub-pixel (112) in grayscale to produce a first frame (302); and illuminating one sub-pixel (110) in grayscale and illuminating the other sub-pixel (112) based on the signal generated to produce a second frame (304).
